# EUROPEAN PATENT APPLICATION

(11) **EP 0 913 829 A1**
(43) Date of publication of application: **06.05.1999**
(21) Application number: 97830558.9
(22) Date of filing: 31.10.1997
(51) Int. Cl.: G11C 8/04, G11C 16/06

(54) **Memory circuit with improved address signal generator**

(71) Applicant: STMicroelectronics S.r.l., 20041 Agrate Brianza (Milano) (IT)
(72) Inventor: Campardo, Giovanni, 24126 Bergamo (IT); Commodaro, Stefano, 16031 Bogliasco (Genova) (IT); Ghezzi, Stefano, 24048 Treviolo (Bergamo) (IT); Maccarrone, Marco, 27030 Palestro (Pavia) (IT)
(74) Representative: Mittler, Enrico

(57) **Abstract**

The present invention relates to a semiconductor memory device with an improved address signal generator. The memory device comprises an array of memory elements (10), first decoding circuit means (8,15) for decoding a first set of address signals (7,14) for the selection of said memory elements, and second circuit means (4) for the generation internally to the memory of a sequence of values for said address signals (3,11). The second circuit means (4) generates said sequence so that successive values in the sequence differ for the logic state of only one of said address signals (3,11).

## Description

The present invention relates to a memory circuit with an improved address signal generator circuit, used for example in electrically programmable and erasable ROMs in the pre-programming, program verify or erase verify of individual location, operation in which the content of the whole memory is sequentially scanned.

It is known that, in electrically programmable and erasable ROM devices such as Flash EEPROMs, the operations of pre-programming, erase and erase verify involve several accesses to the memory locations. It is thus known to provide circuits dedicated to the generation of the address signals which are internal to the memory, so as not to burden with this duty the processor of the electronic board on which the memory device is mounted.

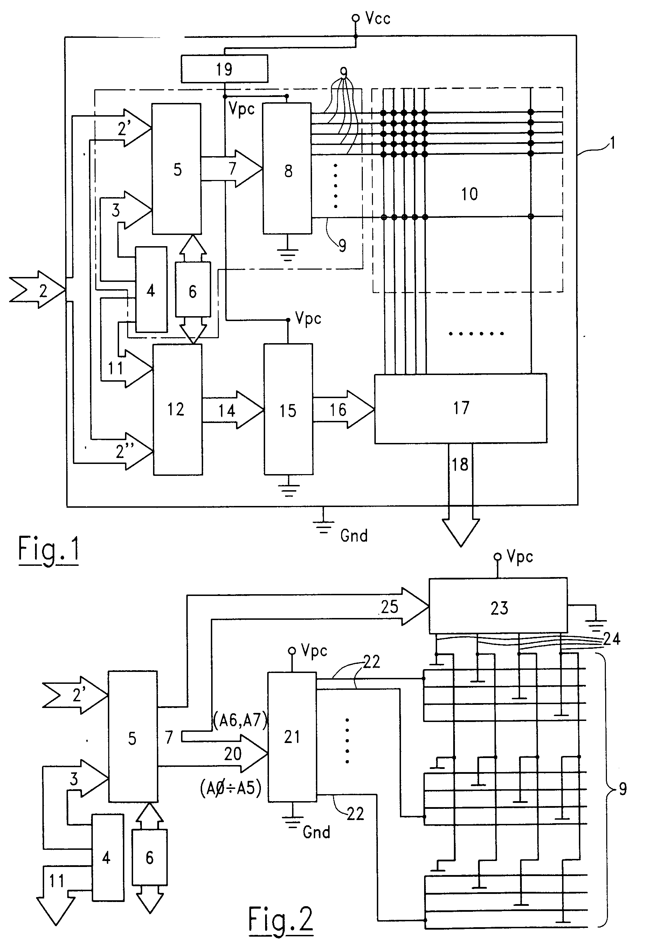

Such a memory 1, shown schematically in Figure 1, normally receives in input a set of external address signals 2; a subset 2' of the set of signals 2 is supplied to a multiplexer 5 driven by a suitable internal logic circuitry 6.

An internal address signal generator 4 generates a first set of internal address signals 3, which supply the multiplexer 5 together with signals 2'.

Output signals 7 from the multiplexer 5 supply a row decoder 8 which generates selection signals 9 for the rows of a memory cell array 10 arranged in rows and columns, each of signals 9 selecting a respective row of said array 10.

Similarly, a subset 2'' of the external address signals 2 and a second set of internal address signals 11 generated by circuit 4 are supplied to a multiplexer 12 driven by the logic circuitry 6, the output signals 14 thereof supplying a column decoder 15 that generates column selection signals 16 used by a column selection circuitry 17. The column selection circuitry 17 detects the information contained in the single memory location addressed by the combination of the selection signals 9 and 16 by means of an internal sensing circuitry, and said information is transferred to digital output signal lines 18 by means of sense amplifiers.

Depending on the memory being operated in one of the above-referred phases or in normal reading conditions, the circuitry 6 drives the multiplexer 5 to select which of the sets of address signals 2' and 3 is to be selected. The logic circuitry 6 similarly drives the multiplexer 12 so as to discriminate between the address signals 2'' and 11.

Typically, circuit 4 generates a sequence of values for the address signals 3, 11 according to the binary coding of the decimal system, i.e.:
- 0: 0000 0000
- 1: 0000 0001
- 2: 0000 0010
- 3: 0000 0011
- 4: 0000 0100
- .:
- .:

It can be noted that with this kind of coding, going from one value to the next the number of bits that vary can be quite high.

The memory 1 in Figure 1 is connected to external supply line Vcc and reference line Gnd. It is thus a single power supply memory device wherein there is not provided an external terminal for the connection to a programming voltage. In the common practice Vcc is kept at voltage levels even lower than 5 V, e.g. 3 V or less, while Gnd is at zero potential. In order to perform the pre-programming, program verify or erase verify operations for the individual memory cells, through higher charge-discharge currents, it is common practice to use voltage boosting circuit or charge pumps 19 that, starting from the external voltage supply Vcc, generate a higher voltage Vpc by which the row and column decoder circuits 8, 15 are supplied. Said boosting circuits 19 cannot however be considered ideal voltage generators, because their operation is highly affected by the load applied thereto. Due to these non-ideality, since when the logic gates composing the row and column decoder circuits 8, 15 switch conductive paths between the output voltage Vpc of the boosting circuit 19 and Gnd can be created, voltage Vpc lowers in value.

The solution shown in Figure 1, even if simple, is not practically used due to the high number of inputs of each logic gate of which the row and column decoder circuits 8 and 15 are composed, said number of inputs equal to the number of row address signals or, respectively, column address signals. This causes problems, not only of space, but also of delays in the propagation of the address signals, with asymmetries in the rising and falling edges of the address signals and the generation of spikes.

It is thus preferred to have a multiple-level decoding scheme, providing for having a decoder (Figure 2 relates to the row decoder 8 of Figure 1) wherein the selection of the rows is made on successive levels. At a first level, conventionally called "level L", packets of rows are determined; the individual rows inside the packets are selected by the second level, known as "level P".

In Figure 2 there is shown that the inputs 20 to a first level (level L) row decoder 21 are a part (e.g., the six least significant bits) of the address signals 7 at the output of the multiplexer 5. The circuitry of the row decoder 21 determines packets 22 of rows, in this example 64 packets of four rows each. The individual row in each packet is then determined by each of the outputs 24 (four in this example) of a second level (level P) row decoder 23. The latter receives in input the remaining part 25 (in this example, the two most significant bits) of the address signals 7 at the output of the multiplexer 5.

The circuitries of the level L row decoder 21 and of the level P row decoder 23 are both supplied by the boosted voltage Vpc for the purpose of performing the pre-programming, program verify and erase verify operations, as already mentioned in connection with Figure 1.

Also in this case, the creation of conductive paths between the boosted voltage Vpc and ground Gnd at the active logic gates subjected to switching causes, due to the non-ideality of the boosting circuits, a lowering of the voltage Vpc. If voltage Vpc falls below Vcc, some of the junctions of the components of the boosting circuits can be forward biased, and such junctions would be damaged.

Compared to the situation of Figure 1, it can be noted that in the worst case, a to a change of the address signals 7 and/or 14 corresponds a logic state transition ("1"→"0" or "0"→"1") of at least two gates in the circuitry of the level L row decoder, and an equal number of gates in the level P row decoder. To such transitions, those inside the column decoder are to be added; also the column decoder can be thought as being formed on more than one decoding level. The number of gates simultaneously switching is also increased by signals not switching in perfect simultaneity.

It appears that with the increase of the number of levels of the row and column decoders, the number of logic gates which can be simultaneously activated upon a change of the address signals also increases significantly, so that the load for the boosted voltage Vpc also increases. A similar problem affects the dual voltage supply memories, wherein the programming voltage, higher than Vcc, is supplied externally; switching of the logic gates composing the row and column decoders involves a current absorption and thus a consumption which is higher the larger the number of logic gates simultaneously switching.

However, distributing the decoder circuits 8 and 15 on multiple levels allows to reduce the access rimes to the individual memory locations, because the load to each address signal line 7 is the lower the lower the number of inputs of the logic gates composing the decoder circuits, i.e. the higher the number of levels.

Thus, in view of the state of the art described, an object of the present invention is that of providing a memory circuit with an improved address signal generator, suitable for significantly reducing the problems due to the creation of conductive paths between boosted voltage Vpc and ground Gnd, particularly felt in the case of structures with multiple decoding levels.

According to the present invention. such an object is achieved by means of a semiconductor memory device, comprising an array of memory elements, first decoding circuit means for decoding a first set of address signals for the selection of said memory elements, and second circuit means for the generation internally to the memory of a sequence of values for said address signals, characterized in that said second circuit means generates said sequence so that successive values in the sequence differ for the logic state of only one of said address signals.

The features and advantages of the present invention will be made apparent by the following detailed description of a practical embodiment thereof, illustrated as a non-limiting example in the annexed drawings, wherein:
Figure 1 schematically shows the functional blocks of a semiconductor memory circuit according to the prior art;
Figure 2 shows a semiconductor memory circuit according to the prior art, with schematically indicated the distribution of the row decoder on two levels;
Figure 3 shows a first embodiment of an address generator circuit according to the present invention, with a Gray counter;
Figure 4 shows a second embodiment of an address generator circuit according to the present invention, with a binary counter and a Gray decoder, in the simple case of a three-bits address signal.

With reference to Figure 2, it can be noted that the number of closed paths which originates between the boosted voltage Vpc and ground Gnd is at most equal to the number of logic gates simultaneously switching in consequence of a change in the address signals 2.

The present invention aims at minimizing the number of closed paths, minimizing the number of logic gates switching. It has been noted that the number of switching logic gates increases with the number of address signals whose logic state changes in going from a memory address to the next. However, in the pre-programming, program verify and erase verify phases the address signals do not vary randomly, as in the normal operation of the memory, but are generated by algorithms of the address generator circuit. An address generator circuit 4 based on a logic of generation not binary, of the type previously described, but instead suitable for reducing the number of switchings in the passage from a logic state combination (value) to the next, solves the problem of the prior art.

According to the present invention, an address generator circuit based on the Gray coding is proposed. As known, Gray coding is characteristic for the fact the successive logic state combinations are adjacent, in the sense that a combination differs from the next for the logic state of only one signal.

A part of the truth table of the Gray decoding circuit for the non-limiting example here discussed is shown in Table 1. According to this example of Gray code, the set of memory address is divided in two equal parts, each being the mirrored image of the other except for one digit; in this case, the passage from the code of the decimal number 127 to that of the decimal number 128 forms the symmetry axis of the code.

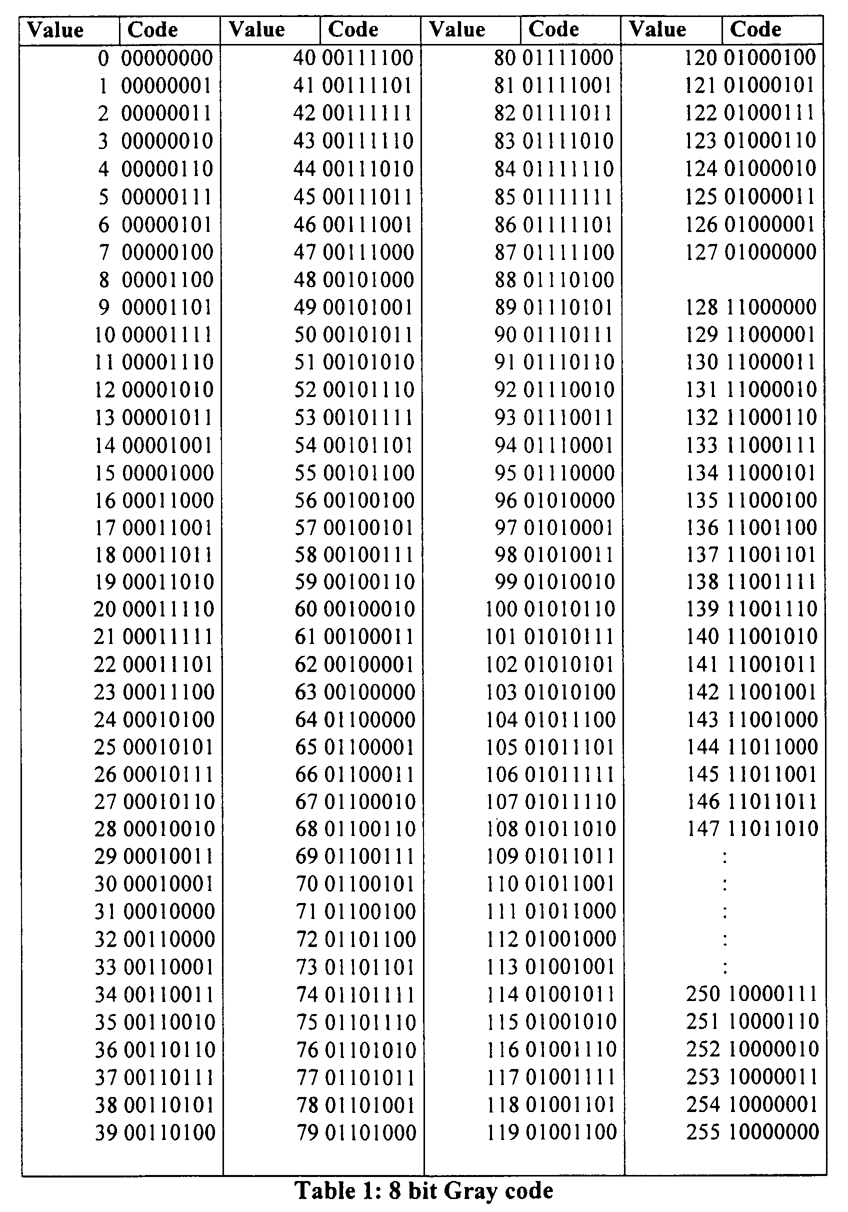

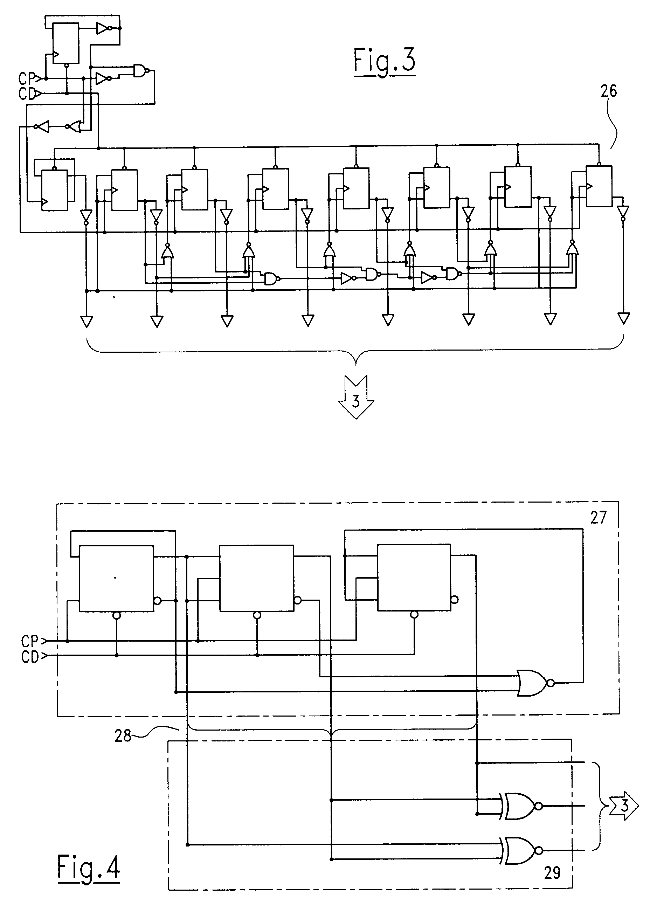

Such a truth table can be practically implemented as shown in Figure 3, wherein the Gray coding is attained by means of a circuit 26 comprising a cascade of flip-flops of which, apart from the first, only one at a time changes of state in going from a logic combination to the next. Circuit 26, differently from a binary counter, comprises a number of flip-flops equal to n+1, where n is the number of bits of the generated code. The first flip-flop of the chain switches at each clock.

Another embodiment of the address generator circuit 4 by means of a Gray-code circuit is shown in Figure 4. In this embodiment the generation of address signals according to the Gray coding is achieved in two steps: for the generation of the signals a binary counter 27 is for example employed, then signals 28 in output from such a circuit are encoded according to the Gray coding by means of a conversion circuit 29. The conversion circuit 29 can also be implemented by means of a purely combinatorial circuit such as a ROM memory. For the sake of simplicity, in Figure 4 a structure for the address generator circuit 4 is shown referring to the exemplifying case of a three-bits coding. The skilled technician will however immediately be able to extend the structure for codes having a larger number of bits.

In the embodiments of Figures 3 and 4 the input signals CD and CP are respectively a reset signal and a clock signal for the circuit.

The specific structure chosen for implementing the adjacent code counter, known as Gray counter, does not affect the features of minimization of undesired effects due to the creation of closed paths between the boosted voltage Vpc and ground Gnd. This feature is offered by the present invention, which guarantees the possibility of using multiple-level decoder circuits in memory circuits.

Even if the previous description has been made in respect of a single voltage supply memory device, it is clear that the present invention also applies to dual voltage supply memory devices, in which the voltage for the program and erase operations is furnished externally.

## Claims

1. Semiconductor memory device, comprising an array of memory elements (10), first decoding circuit means (8,15) for decoding a first set of address signals (7,14) for the selection of said memory elements, and second circuit means (4) for the generation internally to the memory of a sequence of values for said address signals (3,11), characterized in that said second circuit means (4) generates said sequence so that successive values in the sequence differ for the logic state of only one of said address signals (3,11).

2. Memory device according to claim 1, characterized in that said second circuit means (4) comprise a Gray counter (26).

3. Memory device according to claim 1, characterized in that said second circuit means (4) comprise counter means (27) different from a Gray counter, and coding means (29) according to the Gray code for transforming an output sequence from said counter means in a sequence according to the Gray code.

4. Memory device according to claim 3, characterized in that said coding means (29) according to the Gray code comprise a ROM memory.

5. Memory device according to any one of the preceding claims, characterized in that said first circuit means (8,15) comprise a row decoder circuit (8) of a subset of row address signals (7) of said set of address signals (7,14), for the selection of rows of the array (10).

6. Memory device according to claim 5, characterized in that said row decoder circuit (8) comprises a first level row decoder circuit (21) and a second level row decoder circuit (23).

7. Memory device according to any one of the preceding claims, characterized in that said first circuit means (8,15) comprise a column decoder circuit (15) of a subset of column address signals (14) of said set of address signals (7,14) for the selection of columns of the array (10).

8. Memory device according to claim 7, characterized in that said column decoder circuit (15) comprises a first level column decoder circuit (21) and a second level column decoder circuit (23).

9. Memory device according to any one of the preceding claims, characterized by comprising selection circuit means (5,12) for receiving in input internal address signals (3,11) generated by said second circuit means (4) and external address signals (2), and adapted to supply to said first circuit means (8,15) alternatively said internal address signals or said external address signals.

10. Method for generating, internally to a memory device, a succession of values of internal address signals (3,11) for the sequential selection of elements of a memory array (10), characterized in that said succession of values is generated so that each value of the succession differ from adjacent values in the logic state of only one of said address signals (3,11).
